(19) Europäisches Patentamt
European Patent Office
Office européen des brevets

(11) **EP 3 036 763 B1**

(12) **EUROPÄISCHE PATENTSCHRIFT**

(45) Veröffentlichungstag und Bekanntmachung des Hinweises auf die Patenterteilung:
**05.08.2020 Patentblatt 2020/32**

(21) Anmeldenummer: **14752555.4**

(22) Anmeldetag: **18.06.2014**

(51) Int Cl.:
*H01L 23/34* (2006.01)    *H01L 23/473* (2006.01)

(86) Internationale Anmeldenummer:
**PCT/EP2014/001660**

(87) Internationale Veröffentlichungsnummer:
**WO 2014/202218 (24.12.2014 Gazette 2014/52)**

(54) **KÜHLVORRICHTUNG FÜR EIN STROMUMRICHTERMODUL**

COOLING DEVICE FOR A CURRENT CONVERTER MODULE

DISPOSITIF DE REFROIDISSEMENT POUR UN MODULE CONVERTISSEUR ÉLECTRONIQUE DE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.06.2013 DE 102013010088**

(43) Veröffentlichungstag der Anmeldung:
**29.06.2016 Patentblatt 2016/26**

(73) Patentinhaber: **Vensys Elektrotechnik GmbH**
**49359 Diepholz (DE)**

(72) Erfinder: **MEYER, Christoph**
**49356 Diepholz (DE)**

(74) Vertreter: **Joppich, Martin**
**Intellectual Property Consultancy**
**Kanalstraße Nord 216**
**26629 Großefehn (DE)**

(56) Entgegenhaltungen:
| | |
|---|---|
| **EP-A2- 0 993 243** | **EP-A2- 1 577 739** |
| **EP-A2- 2 264 559** | **EP-A2- 2 361 006** |
| **US-A- 4 047 561** | **US-A- 4 051 509** |
| **US-A1- 2006 002 086** | **US-A1- 2008 223 555** |
| **US-A1- 2009 014 156** | **US-A1- 2009 236 081** |
| **US-A1- 2010 253 079** | **US-A1- 2012 227 954** |

**Beschreibung**

Die Erfindung betrifft eine Kühlvorrichtung für ein Stromumrichtermodul.

Bei Anlagen zur Gewinnung elektrischer Energie, etwa bei Windenergieanlagen oder Solaranlagen, werden Stromumrichtermodule eingesetzt, die die erzeugte Gleichspannung bzw. Wechselspannung in eine Spannung mit der vom Netzeinspeisepunkt geforderten Frequenz wandeln. Solche Umrichter können je nach Anwendungsfall eine Leistungsübertragung von einigen kW bis zu einigen MW aufweisen. Im Inneren des Stromumrichtermoduls befinden sich schnell schaltende Leistungshalbleiter, beispielsweise Bipolartransistoren mit isolierter Gate-Elektrode (englisch insulated-gate bipolar transistor, kurz IGBT). Die aufgrund von Umwandlungsvorlusten entstehende Wärme wird an einen oder mehrere Kühlkörper abgegeben. Diese Wärme muss durch eine entsprechende Kühlvorrichtung abgeführt werden, damit der Leistungshalbleiter nicht aufgrund von Überhitzung zerstört wird.

Vorzugsweise wird die an den Kühlkörper abgegebene Wärme direkt an einen Wärmetauscher weitergeleitet, der von einer Kühlflüssigkeit durchströmt wird. Als Kühlflüssigkeit wird aus Korrosions- oder Frostschutzgründen beispielsweise ein Wasser-Ethanol-Gemisch oder ein Wasser-Glykol-Gemisch verwendet.

Die Kühlflüssigkeit wird in einem Kühlkreislauf wiederum einem Luftkühler zugeführt und dort entsprechend abgekühlt, bevor diese wiederum über eine Pumpe zu dem Wärmetauscher des Leistungshalbleiters zurückgeführt wird.

Ein Problem bei einem derartigen Kühlkreislauf kann ein Zustand sein, bei dem die Temperatur an dem Wärmetauscher eines Leistungshalbleiters ausnahmsweise unter die Temperatur der umgebenden Luft absinkt. Dieser Fall kann zum Beispiel bei einem ausgeschalteten Stromumrichtermodul während der Durchführung von Wartungsarbeiten eintreten. Hierdurch resultiert eine Kondensatbildung am Wärmetauscher, die zu einer Beschädigung oder gar auch zu einer Zerstörung von elektronischen Bauteilen führen kann.

EP 2 361 006 A2 offenbart Latenzwärmespeicher und eine Steuer-/ Regeleinheit, die dazu dienen, Temperaturschwankungen der Leistungsbauteile während des Betriebs zu vermeiden.

EP 1 577 739 A2 offenbart einen Kühlkreislauf mit integrierten Heizelementen für einen Computer. Die Heizelemente werden mit gepulsten Signalen beaufschlagt und dienen in diesem Fall dazu Schwingungen im Kühlkreislauf zu erzeugen, die die Kühlleistung erhöhen.

US 2006/002086 A1 offenbart eine Kühlvorrichtung für mehrere Multichip-Module. Jedes Multichip-Modul wird jeweils von einem mit Kühlflüssigkeit beaufschlagten Wärmetauscher gekühlt.

US 2006/002086 A1 gibt keine Hinweise auf die Verwendung einer Heizung im Kühlkreislauf.

Aufgabe der Erfindung ist es, die Kondensatbildung in einer Kühlvorrichtung für ein Stromumrichtermodul zu vermeiden.

Diese Aufgabe wird durch die Merkmale des Patentanspruchs 1 gelöst.

Weitere bevorzugte Ausführungsformen sind durch die Unteransprüche 2 - 5 angegeben.

Weitere Einzelheiten und Vorteile der Erfindung werden anhand der folgenden Figuren erläutert. Es zeigt

Fig. 1    ein Prinzipschaltbild der erfindungsgemäßen Kühlvorrichtung, und

Fig. 2    ein Prinzipschaltbild des gemäß Fig. 1 verwendeten Wärmetauschers.

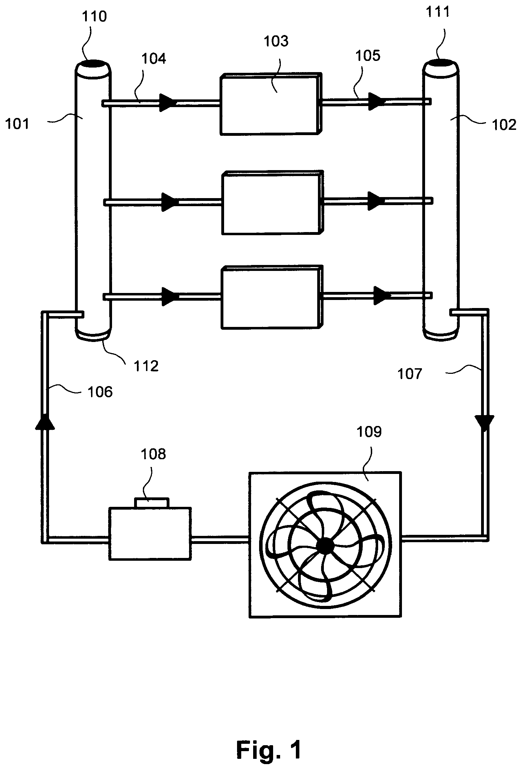

Fig. 1 zeigt ein Prinzipschaltbild der erfindungsgemäßen Kühlvorrichtung.

Die erfindungsgemäße Kühlvorrichtung besteht insgesamt aus einem mit einem flüssigen Kühlmittel betriebenen Kühlkreislauf. Als Kühlmittel wird ein Wasser-Ethanol-Gemisch verwendet. Zusätzlich wird dem Kühlmittel ein Korrosionsinhibitor zugesetzt. Der Inhibitor hält den im Wasser befindlichen Kalk in Lösung und schützt die Stahl-, Aluminium- und Kupfermaterialen der Kühlvorrichtung durch eine Schutzfilmbildung (Sauerstoffdiffusion).

Als Beispiel wird angenommen, dass die Kühlvorrichtung für ein Stromumrichtermodul einer Windenergieanlage oder einer Solaranlage zur Netzeinspeisung vorgesehen ist. Derartige Stromumrichtermodule müssen für Leistungen von einigen kW bis zu einigen MW ausgelegt sein und weisen eine Vielzahl von Leistungsbauelementen auf. Insbesondere in der oben Leistungsklasse von einigen MW ist es vorteilhaft, wenn ein Leistungsbauelement jeweils mit einem Wärmetauscher und einem Kühlflüssigkeitskanal gekoppelt ist.

Als Beispiel wird weiter angenommen, dass in dem Kühlkreislauf 3 IGBT gekühlt werden sollen. Selbstverständlich ist die Erfindung aber auch auf die Kühlung von nur einem IGBT oder auf eine beliebige Vielzahl von IGBT anwendbar.

Von den 3 IGBT ist aus Vereinfachungsgründen nur ein IGBT zusammen mit dem zugehörigen Wärmetauscher mit dem Bezugszeichen 103 gekennzeichnet. Der Wärmetauscher 103 des besagten IGBT ist über den Kühlflüssigkeitskanal 104 im Vorlauf (d.h. in Strömungsrichtung des flüssigen Kühlmittels gesehen hinter dem Kühler und vor dem Wärmetauscher) mit einem senkrecht (d.h. parallel zum Schwerkraftvektor) montierten Verteilerrohr 101 verschaltet. Der Strömungsquerschnitt des Verteilerrohrs 101 ist größer als die Strömungsquerschnitte der zu- und abführenden Kühlflüssigkeitskanäle.

In entsprechender Weise ist der Wärmetauscher 103 des besagten IGBT über den Kühlflüssigkeitskanal 105 im Rücklauf (d.h. in Strömungsrichtung des flüssigen Kühlmittels gesehen hinter dem Wärmetauscher und vor dem Kühler) mit einem ebenfalls senkrecht (d.h. parallel zum Schwerkraftvektor) montierten Verteilerrohr 102 verschaltet. Der Strömungsquerschnitt des Verteilerrohrs 102 ist wiederum größer als die Strömungsquerschnitte der zu- und abführenden Kühlflüssigkeitskanäle.

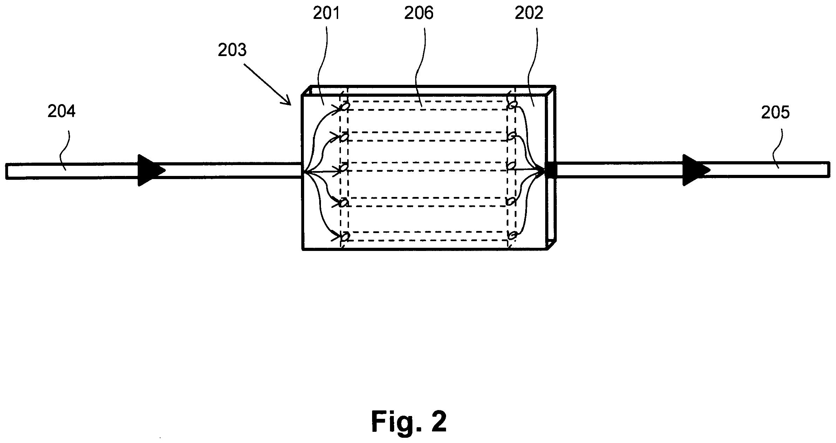

Die Funktion des Wärmetauschers wird unten anhand von Fig. 2 weiter erläutert. An dieser Stelle wird ergänzend noch auf die Montagerichtung des Wärmetauschers mit Bezug auf den Schwerkraftvektor eingegangen. Die Darstellungen in Fig. 1 und Fig. 2 zeigen eine Montagerichtung parallel zum Schwerkraftvektor (d. h. der Schwerkraftvektor liegt in der Zeichenebene). Diese Montagerichtung ist aus Platzgründen oft notwendig (und wurde aus Darstellungsgründen hier gewählt), ist aber für die Funktion der gesamten Kühlvorrichtung keineswegs zwingend. Ein Nachteil dieser Montagerichtung ist die Tatsache, dass sich möglicherweise Luftbläschen im oberen Teil eines jeden Wärmetauschers 103 sammeln können. Eine andere Möglichkeit eines jeden Wärmetauschers 103 ist daher die Montagerichtung senkrecht zum Schwerkraftvektor, d.h. der Schwerkraftvektor steht dann senkrecht auf der Ebene eines jeden Wärmetauschers 103. In diesem Fall verteilen sich Luftbläschen gleichmäßig im Wärmetauscher und können über die Kühlflüssigkeit umgehend wieder abgeführt werden.

Im Verteilerrohr 102 wird das Kühlmittel für den Rücklauf gesammelt und über den Kühlflüssigkeitskanal 107 an einen Luftkühler 109 geleitet. Der Luftkühler 109 kühlt die Temperatur des Kühlmittels auf ein erforderliches Maß herab und führt das Kühlmittel erneut dem Kühlkreislauf in den Vorlauf zu.

In Strömungsrichtung des Kühlmittels gesehen hinter dem Luftkühler 109 befindet sich die Pumpe 108, die die Zirkulation des Kühlmittels innerhalb des Kühlkreislaufs unterstützt und aufrechterhält. Wenn man die natürliche Konvektion der Kühlflüssigkeit für die Zirkulation des Kühlmittels ausnutzen möchte (d.h. warme Kühlflüssigkeit steigt entgegen dem Schwerkraftvektor nach oben und kalte Kühlflüssigkeit sinkt mit dem Schwerkraftvektor nach unten), dann ist es erforderlich, dass der Luftkühler 109 mit Bezug auf den Schwerkraftvektor am höchsten Punkt des Kühlkreislaufs installiert ist. Die Verschaltung des Luftkühlers in Fig. 1 ist dann entsprechend abzuändern.

Über den Kühlflüssigkeitskanal 106 gelangt das Kühlmittel schließlich wieder in den Vorlauf und damit in das Verteilerrohr 101, das die Kühlflüssigkeit zu den IGBT 103 weiterleitet.

Oberhalb des Verteilerrohrs 101 bzw. 102 befindet sich ein Entlüftungsventil 110 bzw. 111. Das Entlüftungsventil 110 bzw. 111 wird mechanisch durch eine Membran gesteuert, die bei Austrocknung sich zusammenzieht und bei Berührung mit Wasser sich wieder ausdehnt.

Das Entlüftungsventil 110 bzw. 111 kann jeweils in beiden Verteilerrohren 101 und 102 installiert sein. Die Funktionsweise des Entlüftungsventils ist aber auch noch gewährleistet, wenn es entweder in dem Verteilerrohr 101 oder in dem Verteilerrohr 102 installiert ist.

Die folgende Beschreibung bezieht sich nur auf das Entlüftungsventil 110.

Gelangt nun Luft in den Kühlkreislauf, so wird die Luft in Form von Luftbläschen solange durch den Kühlkreislauf transportiert, bis diese in das Verteilerrohr 101 gelangt. Dabei ist der Strömungsquerschnitt des Verteilerrohrs 101 größer als der Strömungsquerschnitt des Kühlflüssigkeitskanals 104. Dies bewirkt, dass die Strömungsgeschwindigkeit des Kühlmittels im Verteilerrohr 101 kleiner ist als die Strömungsgeschwindigkeit des Kühlmittels im Kühlflüssigkeitskanal 104, sodass die Luftbläschen genügend Zeit haben, in dem Verteilerrohr 101 zum Entlüftungsventil 110 aufzusteigen.

Gleiches gilt auch für das Entlüftungsventil 111 im Verteilerrohr 102 mit dem angeflanschten Kühlflüssigkeitskanal 105.

Das Verteilerrohr 102 kann mit Bezug auf den Schwerkraftvektor auf gleicher Höhe wie das Verteilerrohr 101 montiert sein, so wie dies in Fig. 1 gezeigt ist. Diese Montageweise ist allerdings nicht zwingend erforderlich. Eine andere bevorzugte Montageweise besteht beispielsweise darin, dass das Verteilerrohr 102 mit Bezug auf den Schwerkraftvektor höher montiert ist als der höchst montierte Wärmetauscher. Auf diese Weise können Luftbläschen, die sich in den Wärmetauschern gesammelt haben oder dort bilden, wirkungsvoll bis in das Verteilerrohr 102 transportiert werden und dort über das Entlüftungsventil 111 entlüftet werden.

Für die Ausgestaltung des Entlüftungsventils gibt es mehrere Möglichkeiten. Beispielsweise kann das Luftablassventil von einer Membran gesteuert werden, die sich im trockenen Zustand zusammenzieht und damit das Luftablassventil öffnet und die sich bei Berührung mit Wasser ausdehnt und das Luftablassventil schließt. Eine andere Möglichkeit besteht darin, dass das Luftablassventil mit einer Steuereinheit verbunden ist und von der Steuereinheit zum Ablassen von Luft geöffnet wird, sobald ein Lufteinschluss-Sensor innerhalb des Verteilerrohrs in der Nähe des Luftablassventils eine Luftmenge feststellt, die ein vorgegebenes Maß überschreitet. Der Lufteinschluss-Sensor kann beispielsweise auf dem Signal eines Schwimmers basieren, dessen Pegel ausgewertet wird.

Unterhalb des Verteilerrohrs 101 bzw. 102 befindet sich eine Heizung 112. Die Heizung 112 kann beispielsweise aus einer in das Verteilerrohr 110 führenden Heizspirale bestehen, die bei Bedarf entsprechend mit Strom beaufschlagt wird.

Die Heizung 112 dient dem Zweck, dass der Wärmetauscher über eine Erwärmung des Kühlmittels bei Bedarf erwärmbar ist, und zwar für den Fall, dass einer oder mehrere Wärmetauscher ausnahmsweise einmal eine niedrigere Temperatur als die Umgebungsluft annehmen. Zur Detektierung dieses Ausnahmefalls sind außerdem entsprechende Temperatursensoren vorgesehen.

Der besagte Ausnahmefall tritt in der Regel dann ein, wenn das Stromumrichtermodul nicht in Betrieb ist (zum Beispiel wegen Wartungsarbeiten) und gleichzeitig die Umgebungsluft sich aufgrund von äußerer Sonneneinstrahlung erwärmt (zum Beispiel in den Morgenstunden). Für diesen Fall bildet sich Kondenswasser an dem Wärmetauscher 103 sowie auch an den Kühlkörpern der IGBT und an den IGBT selber, was zu Korrosion oder aber auch zu der Zerstörung von elektrischen Komponenten führen kann.

Wird somit der besagte Ausnahmefall durch eine Steuereinheit detektiert, dann schaltet die Steuereinheit die Heizung 112 ein. Dies bewirkt nunmehr, dass die Wärmetauscher 103 nicht gekühlt, sondern vielmehr leicht erwärmt werden, sodass eine Kondensatbildung verhindert werden kann. Zur Aufrechterhaltung des zirkulierenden Kühlmittels (bzw. jetzt Wärmemittels) ist die Pumpe 108 insbesondere dann nicht erforderlich, wenn die Heizung sich mit Bezug auf den Kühlkreislauf (bzw. jetzt Wärmekreislaufs) in einer Steigleitung befindet.

Fig. 2 zeigt ein Prinzipschaltbild des gemäß Fig. 1 verwendeten Wärmetauschers.

Die Komponenten 203, 204 und 205 entsprechen den Komponenten 103, 104 und 105 aus Fig. 1.

An der Rückseite des Wärmetauschers 203 ist der Kühlkörper eines IGBT angeflanscht.

Innerhalb des Wärmetauschers 203 sind zwei Verteiler 201 und 202 vorgesehen, zwischen denen parallele Rohrleitungen 206 verschaltet sind. Die parallelen Rohrleitungen 206 erweitern durch ihre Parallelschaltung den effektiven Strömungsquerschnitt des Wärmetauschers 203 und verhindern gleichzeitig das Ausbilden von turbulenten Strömungen. Vorzugsweise sind in dem Wärmetauscher gerade so viele Rohrleitungen parallel geschaltet sind, dass der Druckverlust am Wärmetauscher nicht mehr als 10% des Arbeitsdrucks des Kühlkreislaufs beträgt.

Insgesamt wird durch die Parallelschaltung der Rohrleitungen innerhalb des Wärmetauschers 103 sichergestellt, dass der Wärmetauscher 103 mit Bezug auf den gesamten Kühlkreislauf keinen zu großen Strömungswiderstand darstellt, sodass die Temperaturdifferenz am Wärmetauscher 103 zwischen dem Vorlauf 104 und dem Rücklauf 105 auf einem niedrigen Maß gehalten werden kann.

Vorzugsweise liegt die Temperaturdifferenz stets unterhalb von 10 Kelvin, besonders vorzugsweise unterhalb von 5 Kelvin. Durch die niedrige Temperaturdifferenz ist wiederum gewährleistet, dass der betreffende IGBT gleichmäßig gekühlt wird, was die Betriebsdauer erhöht und die Ausfallwahrscheinlichkeit verringert.

Die Einhaltung einer vorgegebenen Temperaturdifferenz am Wärmetauscher ist also besonders erstrebenswert. Daher besteht der Bedarf nach einer technischen Lehre, die es erlaubt, auf einfache Weise und ohne aufwendige Versuche eine Kühlvorrichtung zu schaffen, mit der die vorgegebene Temperaturdifferenz am Wärmetauscher von vornherein einzuhalten ist.

Eine derartige technische Lehre ist erfindungsgemäß zumindest dann möglich, wenn von einer Topologie und von den Randbedingungen der Kühlvorrichtung ausgegangen werden kann, wie diese in Fig. 1 dargestellt und beschrieben sind. Dies bedeutet im Einzelnen:

- Die Kühlvorrichtung ist für die Kühlung von sehr hohen Verlustleistungen vorgesehen (pro Wärmetauscher größer als 1 Kilowatt).

- Ein Wärmetauscher ist für die Kühlung von einem Leistungsbauelement (z.B. IGBT) vorgesehen.

- Im Vorlauf und im Rücklauf befindet sich jeweils ein Verteilerrohr, dessen Strömungsquerschnitt jeweils größer ist als die Strömungsquerschnitte der zu- und abführenden Kühlflüssigkeitskanäle.

- Der Kühler ist in der Lage, das Kühlmedium mit der anfallenden Gesamtverlustleistung zu kühlen.

- Die Pumpe ist in der Lage, in dem Kühlkreislauf mit überbrückten Wärmetauschern (d.h. die Wärmetauscher werden zu diesem Zweck herausgenommen) einen vorgegebenen Volumenstrom V aufrechtzuerhalten.

Der gesuchte Wärmetauscher soll mit der Verlustleistung $P_V$ die Kühlflüssigkeit aufheizen. Für ein Delta-Volumen $\Delta V$ der Kühlflüssigkeit innerhalb des Zeitabschnitts $\Delta t$ gilt damit die folgende Energiebilanz:

$$P_V \cdot \Delta t \ = \ \dot{V} \cdot \Delta t \cdot \rho \cdot c \cdot \Delta T$$

mit

$P_V$     Verlustleistung
$\Delta t$     Zeitabschnitt
$\dot{V}$     Volumenstrom der Kühlflüssigkeit
$\rho$     Dichte der Kühlflüssigkeit
$c$     spezifische Wärmekapazität der Kühlflüssigkeit
$\Delta T$     Temperaturdifferenz am Wärmetauscher

Die Erkenntnis der Erfindung besteht darin, dass mit den oben genannten Randbedingungen und mit einem plattenförmigen Wärmetauscher die Temperaturdifferenz $\Delta T$ tatsächlich eingehalten werden kann, wenn in dem Wärmetauscher mehrere Rohrleitungen in geeigneter Weise parallel geschaltet werden. In einer sehr begrenzten Anzahl von Versuchen kann daher der gesuchte Wärmetauscher geschaffen werden, indem mehrere Rohrleitungen in dem Wärmetauscher derart parallel geschaltet werden, dass die Temperaturdifferenz am Wärmetauscher das vorgegebene Maß $\Delta T$ gemäß der obigen Formel von

$$\Delta T = \frac{P_V}{\dot{V} \cdot \rho \cdot c}$$

nicht überschreitet.

Im Folgenden wird ein Zahlenbeispiel angegeben (der Einfachheit halber für das Kühlmedium Wasser bei 20°C):

Kühlmedium: Wasser
Anzahl der IGBT: 3
Verlustleistung pro IGBT: 1 kW
Volumenstrom insgesamt: 0,15 l/s
Volumenstrom pro Wärmetauscher: 0,05 l/s
Dichte von Wasser bei 20°C: 0,998 kg/l
spez. Wärmekapazität von Wasser bei 20°C: 4182 J/(kg·K) Temperaturunterschied pro Wärmetauscher: 4,8 Kelvin

**Patentansprüche**

1. Kühlvorrichtung für ein elektrisches Leistungsbauelement, die einen mit einem flüssigen Kühlmittelbetriebenen Kühlkreislauf umfasst,
   mit einem Wärmetauscher (103), der in dem Kühlkreislauf verschaltet ist und an dem wärmeleitend das Leistungsbauelement gekoppelt ist, und
   mit einem Kühler (109) zum Kühlen des Kühlmittels, der in Strömungsrichtung des Kühlmittels gesehen hinter dem Wärmetauscher (103) in dem Kühlkreislauf verschaltet ist,
   mit einem langgestreckten Verteilerrohr (101), das in Strömungsrichtung des flüssigen Kühlmittels gesehen hinter dem Kühler (109) und vor dem Wärmetauscher (103) mittels Kühlflüssigkeitskanälen (104, 106) in den Kühlkreislauf geschaltet ist, dessen Strömungsquerschnitt größer ist als der Strömungsquerschnitt des Kühlflüssigkeitskanals und das zum Schwerkraftvektor parallel montiert ist,
   mit einer Pumpe (108), die in dem Kühlkreislauf zur Aufrechterhaltung der Zirkulation des Kühlmittels verschaltet ist,
   **gekennzeichnet durch**
   Temperatursensoren zur Detektion der Temperatur des Wärmetauschers (103) und zur Detektion der Temperatur der Umgebungsluft,
   eine Heizung zur Erwärmung des Kühlmittels, die sich in dem Verteilerrohr (101) befindet,
   wobei eine Steuereinheit die Signale der Temperatursensoren auswertet und die Heizung dann einschaltet, wenn das Leistungsbauelement nicht in Betrieb ist und der Wärmetauscher eine niedrigere Temperatur als die Umgebungsluft annimmt,
   sodass ohne Verwendung der Pumpe (108) das erwärmte Kühlmittel in dem Kühlkreislauf zirkuliert und den Wärmetauscher (103) erwärmt.

2. Kühlvorrichtung nach einem der Ansprüche 1 - 2, wobei das Leistungsbauelement ein Bipolartransistor mit isolierter Gate-Elektrode ist.

3. Kühlvorrichtung nach einem der Ansprüche 1 - 2, wobei das Kühlmittel ein Wasser-Ethanol-Gemisch ist.

4. Kühlvorrichtung nach einem der Ansprüche 1 - 3, wobei die Heizung aus einer Heizspirale besteht, die unterhalb des Verteilerrohrs (101) eingebracht ist.

5. Stromumrichtermodul, das in einer Windenergieanlage oder Solaranlage zur Netzeinspeisung verschaltet ist und eine Vielzahl von Leistungsbauelementen aufweist, die jeweils mit einem Wärmetauscher einer Kühlvorrichtung nach einem der Ansprüche 1 - 4 gekoppelt sind.

**Claims**

1. Cooling device for an electrical power component, comprising a cooling circuit operated with a liquid coolant,
   having a heat exchanger (103), which is connected in the cooling circuit and to which the power component is coupled in a thermally conductive manner, and
   having a cooler (109) for cooling the coolant, which cooler, viewed in the flow direction of the coolant, is connected behind the heat exchanger (103) in the cooling circuit,
   having an elongated distributor pipe (101), which, viewed in the flow direction of the liquid coolant, is connected behind the cooler (109) and in front of the heat exchanger (103) by means of cooling liquid channels (104, 106) in the cooling circuit, the cross-section of which is greater than the flow cross-section of the cooling liquid channel and which is mounted parallel to the gravity vector
   having a pump (108), which is connected in the cooling circuit for maintaining the circulation of the coolant,
   **characterized by**
   temperature sensors for detecting the temperature of the heat exchanger (103) and for detecting the temperature of the ambient air,
   a heater for heating the coolant, which is located in the distributor pipe (101),
   wherein a control unit analyses the signals from the temperature sensors and activates the heater, if the power component is not in operation and if the heat exchanger assumes a lower temperature than the ambient air,
   so that without using the pump (108) the heated coolant is circulated in the cooling circuit and heats the heat exchanger (103).

**2.** Cooling device according to claim 1, wherein the power component is a bipolar transistor with an insulated gate-electrode.

**3.** Cooling device according to one of the claims 1 - 2, wherein the coolant is a water-ethanol-mixture.

**4.** Cooling device according to one of the claims 1 - 3, wherein the heater consists of a heating coil, which is introduced beneath the distributor pipe (101).

**5.** Current converter module, which is connected in a wind power system or solar power system for network supply and has a plurality of power components, each of which is coupled with a heat exchanger of a cooling device according to one of the claims 1 - 4.


**Revendications**

**1.** Appareil de refroidissement pour un composant de puissance électrique, comprenant un circuit de refroidissement fonctionnant avec un agent de refroidissement liquide,
avec un échangeur de chaleur (103), qui est relié dans le circuit de refroidissement et auquel le composant de puissance est couplé de manière thermoconductrice,
avec un refroidisseur (109) destiné à refroidir l'agent de refroidissement, lequel refroidisseur, vu dans la direction d'écoulement d'agent de refroidissement, est connecté derrière l'échangeur de chaleur (103) dans le circuit de refroidissement,
avec un tuyau de distribution allongé (101), qui, vue dans la direction d'écoulement d'agent de refroidissement, est connecté derrière le refroidisseur (109) et devant l'échangeur de chaleur (103) au moyen de canaux d'agent de refroidissement (104, 106) dans le circuit de refroidissement, dont la section est supérieure à la section d'écoulement du canal de liquide de refroidissement et qui est montée parallèlement au vecteur de gravité,
avec une pompe (108), qui est relié dans le circuit de refroidissement pour maintenir la circulation d'agent de refroidissement,
**caractérisé par**
des capteurs de température pour détecter la température de l'échangeur de chaleur (103) et pour détecter la température de l'air ambiant,
un dispositif de chauffage pour chauffer l'agent de refroidissement, qui est situé dans le tuyau de distribution (101),
une unité de commande analysant les signaux provenant des capteurs de température et active le dispositif de chauffage, si le composant de puissance n'est pas en fonctionnement et si l'échangeur de chaleur prend une température inférieure à l'air ambiant,

de telle sorte que, sans utiliser la pompe (108), le liquide de refroidissement chauffé circule dans le circuit de refroidissement et chauffe l'échangeur de chaleur (103) .

**2.** Appareil de refroidissement selon la revendication 1, dans lequel le composant de puissance est un transistor bipolaire à électrode de grille isolée.

**3.** Dispositif de refroidissement selon l'une des revendications 1 - 2, l'agent de refroidissement étant un mélange eau-éthanol.

**4.** Dispositif de refroidissement selon l'une des revendications 1 - 3, dans lequel le dispositif de chauffage est constitué d'une bobine de chauffage, qui est introduite sous le tuyau de distribution (101).

**5.** Module convertisseur de courant, qui est connecté dans un système d'énergie éolienne ou un système d'énergie solaire pour l'alimentation en réseau, comprend une pluralité de composants de puissance, dont chacun est couplé à un échangeur de chaleur d'un appareil de refroidissement selon l'une des revendications 1 - 4.

**Fig. 1**

**Fig. 2**

EP 3 036 763 B1

**IN DER BESCHREIBUNG AUFGEFÜHRTE DOKUMENTE**

**In der Beschreibung aufgeführte Patentdokumente**

- EP 2361006 A2
- EP 1577739 A2

- US 2006002086 A1